# EUROPEAN PATENT APPLICATION

(11) **EP 1 912 484 A1**
(43) Date of publication of application: **16.04.2008**
(21) Application number: 06768352.4
(22) Date of filing: 21.07.2006
(51) Int. Cl.: H05K 3/34, H01L 21/60, H05K 1/18

(54) **SOLDER MOUNTING STRUCTURE, METHOD FOR MANUFACTURING SUCH SOLDER MOUNTING STRUCTURE AND USE OF SUCH SOLDER MOUNTING STRUCTURE**

(30) Priority: 28.07.2005 JP 2005219548
(71) Applicant: Sharp Kabushiki Kaisha, Osaka-shi, Osaka-fu 545-0013 (JP)
(72) Inventor: KINOSHITA, Kazuo, Hiroshima 721-0924 (JP)
(74) Representative: Brown, Kenneth Richard
(86) International application number: PCT/JP2006/314474
(87) International publication number: WO 2007/013365

(57) **Abstract**

The camera module structure (10) of the present invention, is a board electrode (2) formed on a printed board (1) and a mounting electrode (4) formed on a camera module (3) mounted on the printed board (1) being joined through a solder joint section (5), and the board electrode (2) and the mounting electrode (4) are aligned by self-alignment. The solder joint section (5) is composed of a first solder (6) and a second solder (7) having different characteristics. Thus, a solder mounting structure wherein a heavy-weight component is joined on the board with solder by self-alignment is provided.

## Description

### TECHNICAL FIELD

The present invention relates to a solder mounting structure, a method for manufacturing such a solder mounting structure and use of such a solder mounting structure, each of which allows comparatively heavy-weight components to be mounted on the structure.

### BACKGROUND ART

As one method of mounting an integrated circuit (IC) package or a chip-shaped electronic component (mounting components) on a board by solder, there has been known of a method in which solder is melted by applying heat from a backside of the board (the surface opposite to the surface on which the electronic components are mounted). In this method, in order to melt the solder, it is required to heat the backside of the board a much higher temperature than a melting temperature of the solder. As a result, bubbles generate on the backside of the board of the solder joint section due to the thermal stress. Furthermore, with this method, the electronic components are pressed by a machine when soldering. This would cause such a problem as short-circuit or misalignment in the soldered section.

In order to solve these problems, there is a method to mount electronic components on the board by self-alignment. Self-alignment is such an effect that the electronic component is lifted by surface tension and stress of the molten solder, and then self-aligns itself on the mounting position on the board by restitution from the stress. In other words, self-alignment is such an effect of the surface tension of the molten solder that transfers an electrode of the electronic component toward an electrode of the board when the solder is melted by the application of heat and spread out on the electrodes of the board.

Thus, self-alignment can align the board and the electronic component being mounted on the board with high precision without forcibly causing the alignment. Therefore, self-alignment is drawing attention among mounting methods for mounting electronic components wherein alignment of high precision is required.

For example, in Non-Patent Document 1, it is disclosed that the alignment of the core of a fiber-optic cable and the center of a light-receiving element is performed by self-alignment. In Non-Patent Document 1, an optical member with the requirement of aligning in comparatively high precision is aligned by the self-alignment.

In addition, for example, in Patent Documents 1 and 2, it is disclosed that mounting of IC packages (Chip Scale Package (CSP)) and chip-shaped electronic components is performed by self-alignment.

Specifically, in Patent Document 1, when mounting an electronic component such as so-called chip component (resistance, capacitor etc.) or an IC component on the printed board (surface mounting), positioning of the electronic component is performed by self-alignment. In Patent Document 1, in order to smoothly perform the self-alignment, the printed board is ultrasonically oscillated at the time of mounting the electronic component.

On the other hand, in Patent Document 2, the effect of self-alignment is increased by appropriately arranging a shape (area) and position of a solder joint section (terminal land) of an IC package component (CSP).

Because the self-alignment utilizes the surface tension of molten solder as described above, the self-alignment has been applied in mounting comparatively light-weight components. For example, alignment such as IC packages (mounting of independent IC bare chips, QFP etc.) and chip-shaped electronic components has been performed by the self-alignment.
PATENT DOCUMENT 1 Japanese Unexamined Patent Publication, Tokukai, No. 2003-188515 (published on July 4, 2003)
PATENT DOCUMENT 2
   Japanese Unexamined Patent Publication, Tokukai, No. 2003-243757 (published on August 29, 2003)
NON-PATENT DOCUMENT 1 Journal of Applied Mechanics, Vol. 62, JUNE 1995, 390-397.

### DISCLOSURE OF INVENTION

### TECHNICAL PROBLEM

However, conventionally, the self-alignment has not been applied with mounting heavy-weight electronic components, because the self-alignment uses the surface tension of molten solder, which if an electronic component being mounted on the board is too heavy will not function and unable to withstand the heaviness. If the surface tension does not function, obviously alignment with high precision may not be performed by the self-alignment.

It is common with camera modules mounted in recent digital still cameras and mobile phones to have multiple functions such as automatic focus function and automatic zooming function. These multifunctional camera modules especially require alignment with high precision.

However, such multifunctional camera modules inevitably have heavy weights, so alignment with high precision by self-alignment has not been performed.

Accordingly, a technology is yearned for, which makes it possible to apply the self-alignment to mounting of heavy-weight electronic components that require especially high precision alignment such as multifunctional camera module.

In Non-Patent Document 1, it is said that in order for self-alignment to occur, the prerequisite condition is that the surface tension functioning between the electronic component and the molten solder matches the weight of the mounting component thereby attaining an elastic balance therebetween. From this description also, it is the current situation that the self-alignment can only be applicable for comparatively light-weight components.

In addition, if the printed board being soldered is ultrasonically oscillated as in Patent Document 1, there is a fear of damaging the electronic component being joined to the printed board.

In addition, even if the shape and the allocation of the solder joint section are appropriately arranged as in Patent Document 2, the self-alignment utilizing the surface tension of the solder will be performed. Consequently, if the electronic component joined to the board is heavy, there is the problem that the surface tension will not function and the self-alignment effect will not be obtained.

The present invention is made in view of the aforementioned problems, and an object of the present invention is to provide a solder mounting structure with heavy-weighted components soldered to the board by self-alignment, a method for manufacturing such a solder mounting structure, and a method for using such a solder mounting structure.

### TECHNICAL SOLUTION

Specifically, in order to achieve the object, the solder mounting structure of the present invention is arranged such that a board electrode of a board and a mounting electrode of a mounting component mounted on the board are joined with each other by a solder joint section, and said solder joint section comprises multiple types of solder.

According to the structure, the solder joint section joining the board electrode and the mounting electrode comprises a plurality of solders. Therefore, by using a part of the solder from the plurality of solders to support the mounting component and using the rest of the solder for self-alignment, it is possible to perform alignment by self-alignment while supporting the mounting component. That is, it is possible to manufacture the solder mounting structure with the board electrode and mounting electrode aligned by self-alignment. Consequently, even if the mounting component is heavy, it is possible to perform alignment by self-alignment. Therefore, it is possible to provide a solder mounting structure with the board electrode and the mounting electrode being aligned with high precision.

Conventionally, in order to align a board electrode and a mounting electrode by self-alignment, the mounting component should be light-weight and compact. This is because the mounting component is supported by only the surface tension of a molten solder, and cannot withstand the load of the mounting component.

The solder mounting structure of the present invention is preferably arranged such that the solder joint section comprises first solder with a relatively low melting temperature or surface tension when melted (hereafter "surface tension when melted" will be simply "surface tension") and second solder with a higher melting temperature or surface tension than the first solder.

According to the structure, the solder joint section comprises first solder with a low melting temperature or surface tension, and second solder with a higher melting temperature or surface tension than the first solder.

Thus, in the case the melting temperature of the first solder is lower than the second solder, if heated higher than the melting temperature of the first solder though lower than the melting temperature of the second solder when forming the solder joint section, the first solder will melt whereas the second solder will not melt. Therefore, it is possible to perform alignment by the self-alignment effected by the molten first solder while having the unmelted second solder supporting the mounting component.

In addition, in the case the surface tension of the first solder is lower than the second solder, if both the first solder and second solder are melted when forming the solder joint section, the first solder with the low surface tension will spread whereas the second solder with the high surface tension will not spread as much. Therefore, it is possible to perform alignment by the self-alignment of the first solder with the lower surface tension while supporting the mounting component with the second solder having a higher surface tension.

In addition, in the structure, it is only required to have either one of the melting temperature or surface tension of the first solder lower than the second solder.

In the solder mounting structure of the present invention, said board electrode and mounting electrode are preferably covered with said solder joint section.

According to the structure, since the solder joint section is formed covering the board electrode and the mounting electrode, the board and the mounting component are securely joined. Therefore, it is possible to provide a solder mounting structure with a high joint reliability.

In the solder mounting structure of the present invention, said second solder is preferably spherical, and is sandwiched between a recess section of said board electrode and a recess section of said mounting electrode.

According to the structure, the spherical second solder is sandwiched between a recess section of the board electrode and a recess section of the mounting electrode. Therefore, the self-alignment position will be where the recess sections on each of the board electrode and mounting electrode face each other. Thus, at the time of self-alignment, the second solder is securely fixed at the recess sections of each electrode. Therefore, it is possible to align the board electrode and the mounting electrode with a higher precision.

In the solder mounting structure of the present invention, said second solder is preferably formed having plane contact with the board electrode and the mounting electrode.

According to the structure, since the second solder has plane contact with the first electrode and the second electrode, the mounting component is securely supported.

In the solder mounting structure of the present invention, said multiple types of solder are preferably a Pb-free solder. Thus, it is possible to provide a solder mounting structure using an environmentally-friendly solder.

In the solder mounting structure of the present invention, said mounting component may be an optical element. For example, this optical element is preferably a camera module.

Optical elements such as camera modules mounted on digital still cameras and mobile phones are especially required to mount on the board with highly precise alignment.

According to the structure, it is possible to align these optical elements by self-alignment with high precision.

In the solder mounting structure of the present invention, the solder joint section may have a larger proportion of the first solder than the second solder. Thus, the surface tension will function more easily, and self-alignment is smoothly performed.

In the solder mounting structure of the present invention, the solder joint section may have a larger proportion of the second solder than the first solder. Thus, even in the case the mounting component is heavy, it is possible to securely support the mounting component.

The method of the present invention for manufacturing solder mounting structure, in order to achieve the above object, is a method for manufacturing a solder mounting structure in which a board electrode of a board and a mounting electrode of a mounting component mounted on the board are joined with each other by a solder joint section, the method including forming the solder joint section comprising multiple types of solder, and aligning the board electrode and the mounting electrode by self-alignment effected by the multiple types of solder.

According to the method, since the solder joint section is formed from multiple types of solder, by using a part of the solder from the multiple solder to support the mounting component, and using the rest of the solder for self-alignment, it is possible to perform alignment by the self-alignment while supporting the mounting component. Thus, it is possible to perform alignment by the self-alignment even if the mounting component is heavy. Accordingly, it is possible to manufacture a solder mounting structure with the board electrode and the mounting electrode being aligned with high precision.

In the method of the present invention for manufacturing solder mounting structure, a first solder with a relatively low melting temperature and a second solder with a higher melting temperature than the first solder may be used as said multiple types of solder, and the first and second solder may be heated to a temperature equal to or higher than the melting temperature of the first solder though lower than the melting temperature of the second solder.

According to the method, solders with different melting temperatures are used, and are heated to a temperature equal to or higher than the melting temperature of the first solder though lower than the melting temperature of the second solder. Accordingly, the first solder will melt whereas the second solder will not melt. Therefore, it is possible to align the board electrode and the mounting electrode with high precision by the self-alignment of the molten first solder, while supporting the mounting component being mounted to the board by the second solder.

In the method of the present invention for manufacturing the solder mounting structure, a first solder with a relatively low surface tension and a second solder with a higher surface tension than the first solder may be used as the multiple types of solder, and the first and second solder may be heated to a temperature equal to or higher than the melting temperature of the first solder and the second solder.

According to the method, solders with different surface tension are used, and is heated to a temperature equal to or higher than the melting temperature of the first solder and the second solder. Thus, if the first solder 6 and second solder 7 are melted, the first solder with the relatively low surface tension is more readily spread than the second solder. Therefore, it can perform alignment by self-alignment effected by the first solder with low surface tension, while supporting the mounting component with the second solder having the relatively high surface tension.

In the method of the present invention for manufacturing solder mounting structure, the second solder may be a solder ball.

According to the method, since the second solder is a solder ball, the second solder rotates accordingly to the relatively horizontal movement of the board and mounting board due to the molten first solder. Therefore, self-alignment progresses smoothly.

With the method for manufacturing solder mounting structure of the present invention, a solder paste may be used as the solder. Thus, the solder may be applied easily.

The electronic device of the present invention comprises any one of the aforementioned solder mounting structures.

According to the structure, it is possible to provide electronic device comprising solder mounting structures with alignment of high precision by self-alignment. For example, it is possible to provide such as mobile phones/digital still cameras.

The method for solder mounting of the present invention, in order to achieve the object, is a solder mounting method by which a board electrode of a board and a mounting electrode of a mounting component mounted on the board are joined with each other by a solder joint section, the method including forming the solder joint section comprising multiple types of solder, and aligning the board electrode and the mounting electrode by self-alignment effected by the multiple types of solder.

According to the structure, similarly with the method for manufacturing solder mounting structure, even if the mounting component is heavy, alignment by self-alignment is possible. Thus, it is possible to align board electrode and mounting electrode with high precision.

### EFFECT OF INVENTION

The solder mounting structure of the present invention, as above, is a structure comprising a solder joint section comprising multiple types of solder. Therefore, even if the mounting component is heavy, it is possible to align a board electrode and a mounting electrode by self-alignment. Accordingly, the effect is attained such that it is possible to provide such solder mounting structures with board electrodes and mounting electrodes being aligned with high precision.

For a fuller understanding of the nature and advantages of the invention, reference should be made to the ensuing detailed description taken in conjunction with the accompanying drawings.

### BRIEF DESCRIPTION OF DRAWINGS

Fig. 1 is a cross sectional view illustrating a solder joint section of a solder mounting structure according to the present invention.
Fig. 2 is a cross sectional view illustrating a formation step of the solder joint section in Fig. 1.
Fig. 3 is a cross sectional view illustrating the formation step of the solder joint section in Fig. 1.
Fig. 4 is a cross sectional view illustrating the formation step of the solder joint section in Fig. 1.
Fig. 5 is a cross sectional view illustrating the formation step of the solder joint section in Fig. 1.
Fig. 6 is a cross sectional view illustrating the formation step of the solder joint section in Fig. 1.
Fig. 7 is a cross sectional view illustrating the formation step of the solder joint section in Fig. 1.
Fig. 8 is a cross sectional view illustrating the formation step of the solder joint section in Fig. 1.
Fig. 9 is a graph illustrating a thermal profile of solder used in the solder joint section in Fig. 1.
Fig. 10 is a plane view of a printed board of the solder mounting structure according to the present invention.
Fig. 11 is plane view of another printed board of the solder mounting structure according to the present invention.
Fig. 12 is a partial sectional view of the solder mounting structure according to the present invention.
Fig. 13 is a sectional view of a solder joint section of another solder mounting structure according to the present invention.
Fig. 14 is a sectional view of a solder joint section of still another solder mounting structure according to the present invention.

### EXPLANATION OF CODES

- 1: Printed board (board)
- 2: Board electrode
- 3: Camera module (mounting component)
- 4: Mounting electrode
- 5: Solder joint section
- 6: First solder
- 7: Second solder (solder ball)
- 10: Camera module structure (solder mounting structure)
- 20a, 20b: Recess section

### BEST MODE FOR CARRYING OUT THE INVENTION

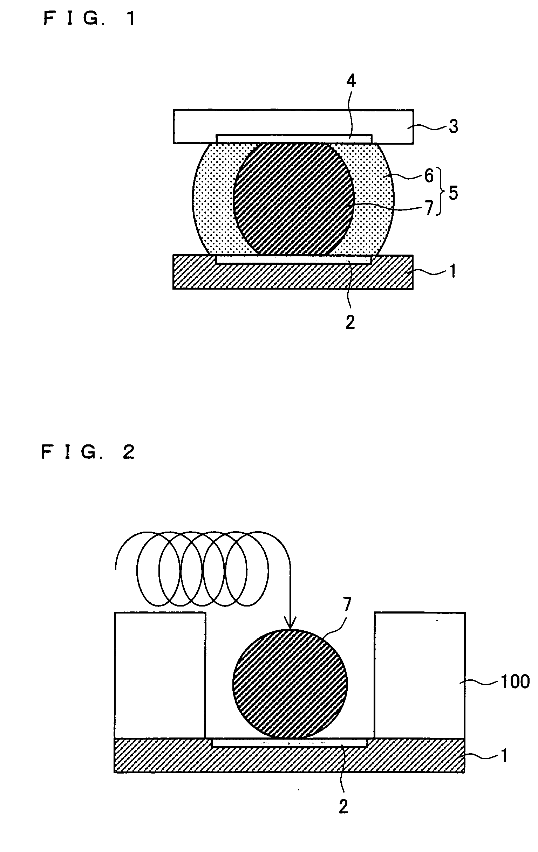

One embodiment of the present invention is described below with reference to Figs. 1 through 14. The present invention is not limited within this.

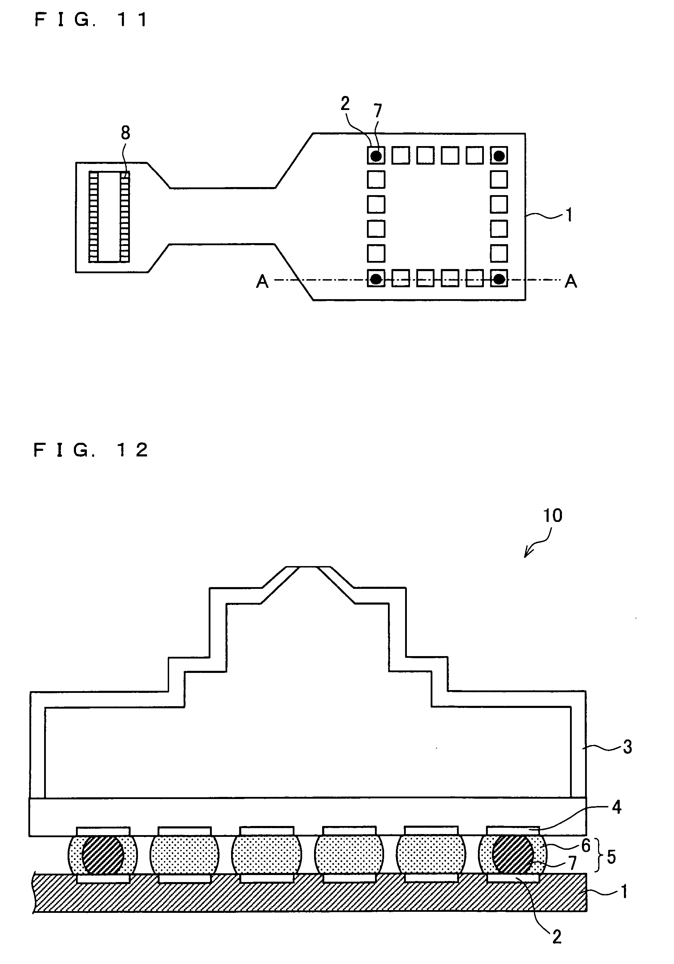

In the present embodiment, as a solder mounting structure, a camera module structure is described. This camera module structure is to be applicable to an electronics device such as mobile phones and digital still cameras. Fig. 12 is a partial sectional view of a camera module structure 10 in the embodiment. Fig. 1 is a cross sectional view of a periphery of a solder joint section in the camera module structure 10. Fig. 11 is a plane view of a printed board 1 of the camera module structure 10 illustrated in Fig.12.

The camera module structure 10 in the present embodiment includes the printed board (board) 1 and a camera module (mounting component; optical element) 3 mounted on printed board 1. The printed board 1 and the camera module 3 are joined with each other via a solder joint section 5. In other words, the camera module structure 10 has such a structure that the camera module 3 is placed on the printed board 1 with the solder joint section (solder pad) 5 therebetween.

The printed board 1, as illustrated in Fig. 11, is a board of a sheet form. On one of the surfaces of the printed board 1, a plurality of board electrodes 2 and connectors 8 are formed.

The board electrodes 2 are for solder-joining the camera module 3. That is to say, in an area with a plurality of board electrodes 2 formed therein, the camera module 3 (not illustrated in Fig. 11) is to be mounted.

The connector 8 is for connecting the camera module 10 with another component. For example, through the connector 8, the image data taken by the camera module 3 is transmitted to another member. As such, the printed board 1 also functions as a relay board.

The camera module 3 is a lens member, which is to be installed in such as mobile phones and digital still cameras. On an undersurface of the camera module 3, a plurality of mounting electrodes 4 are formed corresponding to the board electrodes 2 on the printed board 1. The plural board electrodes 2 and mounting electrodes 4 are positioned to face each other, and are joined together by the solder joint section 5. That is to say, the board electrodes 2 and mounting electrodes 4 are joining terminals.

The board electrodes 2 and mounting electrodes 4 may be metal-plated (gold plate, copper plate, solder plate or the like).

Here, characteristic features of the camera module structure 10 in the present embodiment are described below.

A most remarkable feature of the camera module structure 10 is that the board electrodes 2 and mounting electrodes 4 are aligned by self-alignment, and the solder joint section 5 which joins the board electrodes 2 and mounting electrodes 4 is made of multiple types of solder.

"Alignment of the board electrodes 2 and mounting electrodes 4" is, for example, the position to align the board electrodes 2 and mounting electrodes 4 to face each other, and to arrange the board electrodes 2 and mounting electrodes 4 to designated positions. The present embodiment performs this alignment by self-alignment effected by solders of different characteristics, a first solder 6 and second solder 7.

To attain self-alignment, it is necessary to lift a mounting component by surface tension and stress of molten solder. Therefore, conventional self-alignment is only practiced with comparatively small and light-weight mounting components such as IC packages. The reason of this is, if the self-alignment is performed with heavy-weight mounting components, the molten solder cannot withstand the weight, and the surface tension does not function.

The inventor of the present invention firstly attempted to gain surface tension and stress by using a solder with high surface tension when melted. However, it was found that such solder has a poor wettability which leads to defect in soldering and also to a lower joint reliability. Furthermore, the inventor of the present invention attempted to control the melting state of the solder by temperature adjustment, only to find out that an extremely advanced temperature adjustment is required to do so and therefore this arrangement is realistically unsuitable for bulk production.

As a result of diligent study, the inventor focused attention on the fact that the conventional solder joint section is composed of a single solder, and arrived at the idea of composing the solder joint section with a plurality of solders.

Specifically, in order to align the printed board 1 and camera module 3 (more specifically the board electrode 2 and mounting electrode 4) with high precision by self-alignment, the camera module structure 10 in the present embodiment is arranged such that the solder joint section 5 includes multiple types of solder. That is to say, the solder joint section 5 includes a plurality of solders with different characteristics.

More specifically, in the present embodiment, the solder joint section 5 includes the first solder 6 with a relatively high melting temperature and the second solder 7 with a higher melting temperature than the first solder 6. Thus, when forming the solder joint section 5, by applying heat higher than the melting temperature of the first solder 6 though lower than the melting temperature of the second solder 7, the first solder 6 melts whereas the second solder 7 does not melt. Therefore, self-alignment caused by the surface tension of the first solder 6 while supporting the camera module 3 with the second solder 7 becomes possible. Consequently, it is also possible to align heavy-weight mounting components such as the camera module 3 to the printed board 1 with high precision.

In the solder joint section 5, the proportion of the area of the first solder 6 and the area of the second solder 7 (the occupancy of the first solder 6 and the second solder 7 in the solder joint section 5) is not particularly limited, and may be set depending on the mounting components such as the camera module 3. For example, in the case the mounting component is light, an increase in the proportion of the first solder 6 compared to the second solder 7 makes it easy for the surface tension to function, thereby allowing smooth self-alignment. On the other hand, in the case where the mounting component is heavy such as the camera module 3, an increase in the proportion of the second solder 7 compared to the first solder 6 makes it possible to support the mounting component securely.

In the above structure, the second solder 7 is set in a central part of the solder joint section 5. This makes it possible to support the camera module 3 stably. In addition, since the solder joint section 5 is formed covering the board electrode 2 and mounting electrode 4, the printed board 1 and camera module 3 are securely joined with each other. This provides the camera module structure 10 with a high joint reliability. The formation of the solder joint section 5 will be described later.

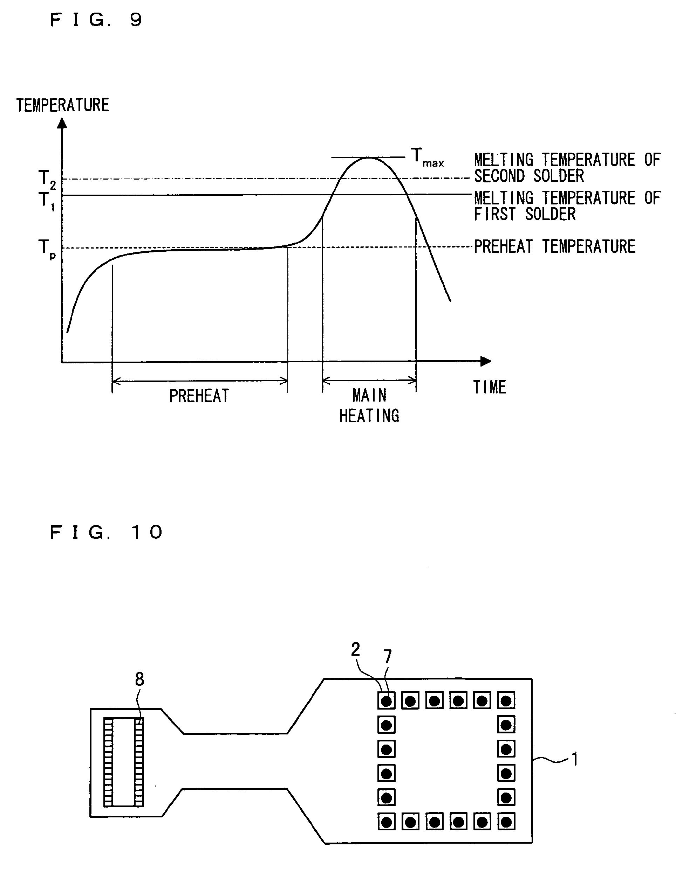

In the embodiment, as in Fig. 11, a plurality of the board electrodes 2 are composed of a structure with a plurality of electrodes positioned in a quadrilateral form. Only the board electrodes 2 positioned on the corners of the quadrangle are joined by the multiple types of solder (the first solder 6 and second solder 7), and the board electrodes 2 positioned other than the corners are joined by only a single solder. However, the solder joint section 5 comprising multiple types of solder may be formed for all the board electrodes 2, as illustrated in Fig. 10.

As such, it is sufficient such that the solder joint section 5 comprising multiple types of solder is formed in at least a part of the board electrodes 2. In addition, the positions of the board electrodes 2 may be set according to the component being mounted, and is not particularly limited.

Next, the method for manufacturing camera module structure 10 in the embodiment is described. Figs. 2 through 8 are cross sectional views illustrating the manufacturing process of the camera module structure 10.

The method for manufacturing camera module structure 10 in the embodiment comprises forming the solder joint section 5 for joining the board electrode 2 of the printed board 1 and the mounting electrodes 4 of the camera module 3 (solder joint section formation step).

The method for manufacturing camera module structure 10 in the embodiment has the feature wherein the solder joint section formation step includes forming the solder joint section 5 with multiple types of solder, and aligning the board electrode 2 and mounting electrode 4 by the self-alignment.

A detailed description of the method for manufacturing camera module structure 10 is as follows.

Firstly, as described in Fig. 2, a solder mask 100 is positioned in order to supply solder to the location of the board electrode 2 on the printed board 1. The solder mask 100 has an opening slightly larger than the location of the board electrode 2. Therefore, when positioning the solder mask 100 to the printed board 1, the location of the board electrode 2 on the printed board 1 is exposed through the opening. Secondly, a solder ball as the second solder 7 is positioned in the opening of the solder mask 100 (that is to say, the exposed portion of the board electrode 2). For example, by scattering the second solder 7 on the solder mask 100, the second solder 7 is easily supplied to the opening of the solder mask 100. That is to say, the second solder 7 is securely supplied to the board electrode 2.

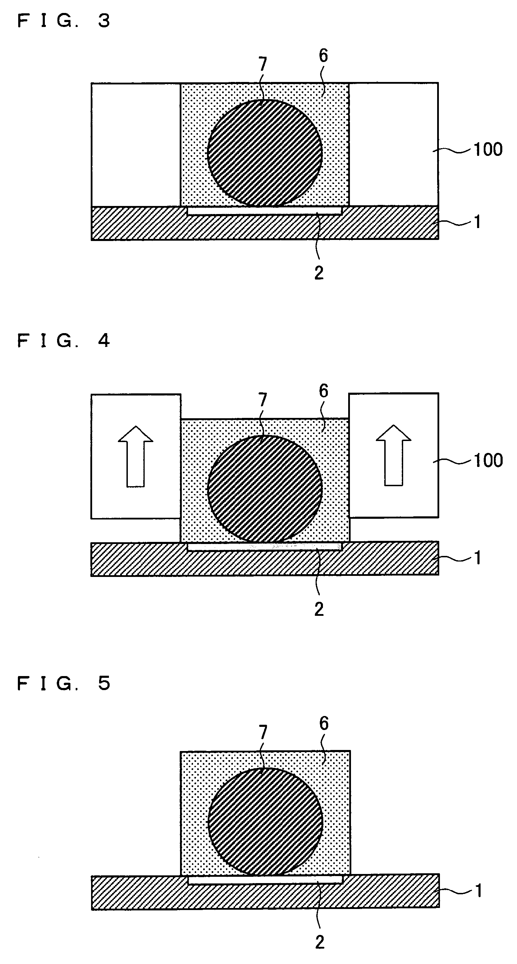

Next, as described in Fig. 3, furthermore, the first solder 6 is applied (printed) from above the solder mask 100. In this embodiment, solder paste is used as the first solder 6, and the first solder 6 is applied to the opening of the solder mask 100 by solder printing. In addition, when applying the first solder 6, the first solder 6 is applied that it covers the second solder 7. Thus, as described in Fig. 3, the second solder 7 is embraced within the inside of the first solder 6.

Next, as described in Fig. 4, after the completion of applying the first solder 6, the solder mask 100 is removed from the printed board 1. Thereby, as described in Fig. 5, the solder joint section 5 (solder pad) comprising the first solder 6 and second solder 7 is formed on the board electrode 2 on the printed board 1. Because the opening of the solder mask 100 is slightly larger than the board electrode 2, the board electrode 2 is covered with the first solder 6 and second solder 7.

In this embodiment, the melting temperature of the first solder 6 is lower than the melting temperature of the second solder 7.

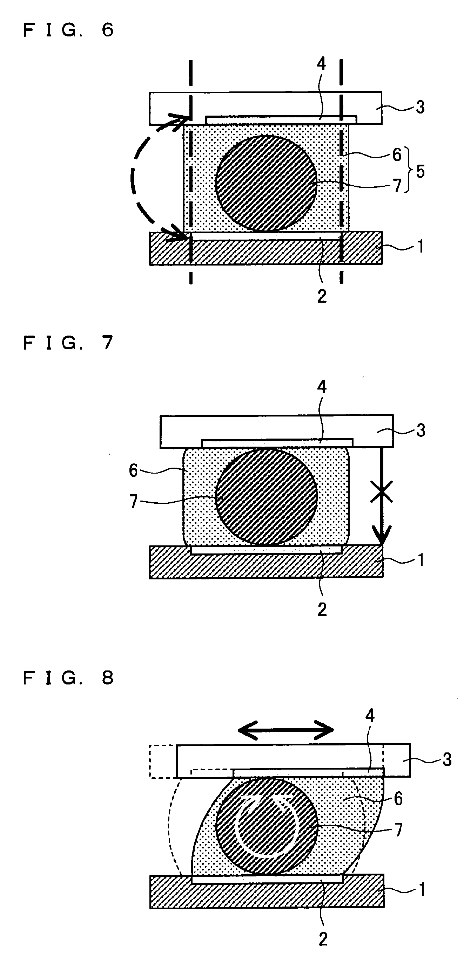

Next, as described in Fig. 6, the camera module 3 is placed onto the solder joint section 5 by an installation machine (carrier device). At this time, the camera module 3 is so positioned that the mounting electrodes 4 of the camera module 3 are facing the board electrodes 2 on the printed board 1.

Here, an alignment in high precision is necessary for the camera module 3. However, the positioning of the camera module 3 by the installation machine cannot attain the adequate alignment of the board electrode 2 and mounting electrode 4. For example, if the board electrode 2 and mounting electrode 4 should be positioned (self-alignment position) so that the board electrode 2 and mounting electrode 4 are opposite each other and the edge of each electrode is respectively aligned, then the alignment of the board electrode 2 and mounting electrode 4 illustrated in Fig. 6 is inadequate, as indicated by the broken line in Fig. 6. Therefore, for example, as indicated by the broken arrow in Fig. 6, it is required to align the board electrode 2 and mounting electrode 4 by moving the camera module 3 to the left side.

In the present embodiment, these inadequate alignments will be corrected by self-alignment effected by the molten solder.

As previously said, the melting temperature of the first solder 6 is lower than the melting temperature of the second solder 7. Therefore, in order to perform the self-alignment, firstly heat is applied higher than the melting temperature of the first solder 6, though lower than the melting temperature of the second solder 7. Thus, as described in Fig. 7, the first solder 6 melts whereas the second solder 7 does not melt. Therefore, even if the first solder 6 melts, the camera module 3 is supported by the second solder 7 that has not melted. As such, the load of camera module 3 is supported not to crush down the first solder 6 and second solder 7 (arrow in figure).

This application of heat may be performed by, for example, a reflow device. In addition, the camera module 3 is supported not just by the second solder 7 but also the surface tension of the molten first solder 6.

In addition, the heat application spreads the first solder 6 horizontally, and as noticed by comparing Fig. 6 and Fig. 7, the thickness (height) of the first solder 6 becomes thinner (lower). That is to say, due to the heat application, the space between the board electrode 2 and the mounting electrode 4 becomes small. In addition, the surface tension functions between the molten first solder 6 and the mounting electrode 4, and the unmelted second solder 7 supports the camera module.

When the first solder 6 is melted in the state in which the camera module 3 is supported by the second solder 7, the horizontal movement of the first solder 6 (arrow in figure) becomes possible due to elasticity stress, as described in Fig. 8. This movement causes the alignment of the board electrode 2 and the mounting electrode 4 (broken line in figure). Thus, the self-alignment is performed by the first solder 6 for effecting to the elasticity stress to cause the alignment, and by the second solder 7 for supporting the camera module 3.

In the present embodiment, since the solder ball is used as the second solder 7, the second solder 7 also rotates accordingly to the relatively horizontal movement of the printed board 1 and camera module 3 in response to the first solder 6. Therefore, self-alignment progresses smoothly.

Lastly, by elevating the heating temperature higher than the melting temperature of the second solder 7, the second solder 7 also melts, as illustrated in Fig. 1. After this, by cooling the molten second solder 7, the formation of the solder joint section 5 is completed. Thus, the second solder 7 will have plane contact with the board electrode 2 and mounting electrode 4. Therefore, it is possible to securely support the camera module 3.

The temperature to melt the second solder 7 is sufficient with a higher temperature than the melting temperature of the second solder 7, however is preferably around the degree it adheres with the board electrode 2 and mounting electrode 4. Thus, the reliability of the solder joint is ensured.

As such, the present embodiment can make it possible to attain the effect of the self-alignment due to the surface tension of the molten first solder 6 while supporting the camera module 3 with the second solder 7 may be obtained. Therefore, even if in case where comparatively heavy-weight members such as the camera module 3 are mounted to the printed board 1, the problem that self-alignment effect may not be achieved due to the load of the camera module 3 is solved.

On the other hand, since the solder joint section 5 is conventionally composed of a single (one type) solder, the camera module 3 is supported only by the surface tension of the molten solder. That is, the camera module 3 is supported only by the surface tension of the first solder 6. However, heavy-weight mounting components such as the camera module 3 cannot be supported just by the surface tension which maintains the solder joint quality in good condition, whereby self-alignment cannot be attained. In addition, if a solder with a high surface tension when melted is used as the single solder in order to obtain the surface tension and stress of the molten solder, the high surface tension causes defective soldering (nonwetting) and poor reliability.

In the present embodiment, the first solder 6 and second solder 7 may be composed of one type of solder respectively, or may be composed of multiple types of solder with different characteristics. For example, the plural types of solders may have different melting temperatures and/or surface tensions. That is to say, the solder to mainly perform self-alignment is the first solder 6, and the solder to mainly support the camera module 3 becomes the second solder 7, and if each solder has those functions respectively, the type (number) of solder is not limited.

In addition, the present invention is not particularly limited to the present embodiment, in which after supplying to the opening of the solder mask 100 the second solder 7, the first solder 6 is supplied. The first solder 6 and the second solder 7 may be supplied in any order. They may be supplied at the same time, or the first solder 6 may be supplied before the second solder is supplied.

In addition, in the embodiment, the second solder 7 is melted (see Fig. 1), however the second solder 7 does not always require melting, and may stay in the form of the solder ball (ball form). That is to say, the second solder 7 may be either melted or not melted.

In addition, in the embodiment, as illustrated in Fig. 11, the second solder 7 is positioned in a part of the board electrode 2, however the second solder 7 may be positioned in any arbitrary board electrode 2, and the second solder 7 may be positioned for all the board electrode 2 as illustrated in Fig. 10.

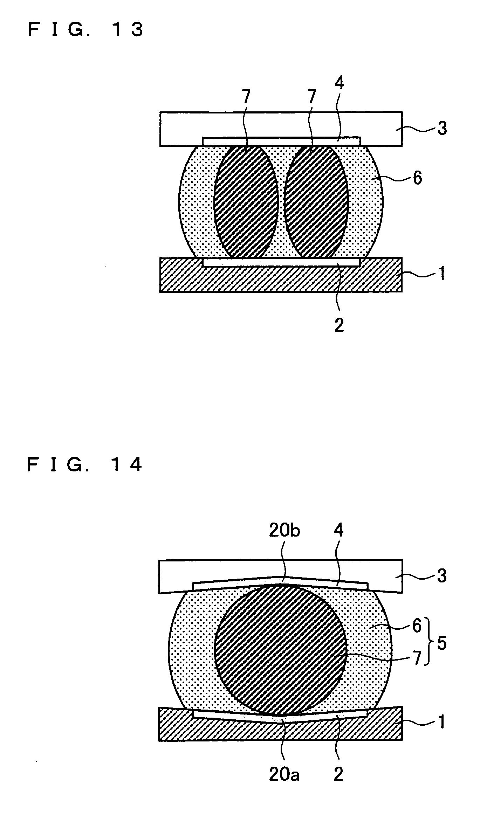

In addition, in the present embodiment, the second solder 7 supplied to the opening of the solder mask 100 are supplied one each per one board electrode 2. However, a plurality of second solders 7 may be supplied to the board electrode 2. Fig. 13 is a cross sectional view illustrating an example with two second solders 7 formed in the solder joint section 5. As illustrated in Fig. 13, the solder joint section may have a plurality of portions in which the second solder 7 is formed.

In the present embodiment, solders with different melting temperatures were used as the first solder 6 and second solder 7, however the melting temperature and the melting time of the first solder 6 and second solder 7 may be set considering the heat resistance of the components to be installed on the printed board 1 (camera module 3). That is to say, the melting temperature and the melting time of the first solder 6 and second solder 7 are not particularly limited, provided that the melting temperature and the melting time of the first solder 6 and second solder 7 will not damage the printed board 1 and camera module 3.

For example, Fig. 9 is a graph describing a thermal profile of the solder used in the solder joint section 5. Fig. 9 is an actual thermal profile for melting solder in soldering the camera module 3 on the printed board 1. As illustrated in Fig. 9, the solder is temporally kept at a preheat temperature lower than the solder melting temperature of the first solder 6, thereby evenly distributing the temperature over the printed board 1 (preheat). After this, the solder is heated a temperature equal to or higher than the melting temperature of the solder, and is rapidly cooled in order to prevent the graining of solder (main heating).

In Fig. 9, if the mounting peak temperature restricted by the heat resistance of the camera module 3 is represented as Tmax, the melting temperature of first solder 6 (T1) should be equal to or under Tmax. However, the melting temperature of the second solder 7 (T2) may be equal to or higher than Tmax. In addition, the temperature is usually elevated gradually from room temperature, and is then kept temporally at a temperature under the melting temperature of the first solder 6 (T1), thereby performing the preheat. After this, the temperature is elevated to the temperature equal to or higher than the melting temperatures of the first solder 6 and second solder 7, and is rapidly cooled.

These processes vary depending on such as the composition of the solder, flux, and the target of the soldering quality. The thermal profile of Fig. 9 is one of a general kind.

For example, the melting temperature of the first solder 6 is preferably in a range of 140°C to 219°C, and is more preferably in a range of 183°C to 190°C. The second solder 7 is not particularly limited as long as it has a higher melting temperature than the first solder 6. In addition, the difference in melting temperature between the first solder 6 and second solder 7 is not particularly limited. However, a greater difference in the temperature makes it possible to more securely melt the first solder 6 only.

In addition, the first solder 6 and the second solder 7 are not limited to solders with different melting temperatures, and is sufficient as long as the first solder 6 and the second solder 7 are solders with different characteristics. For example, the first solder 6 and second solder 7 may be solders with different surface tension when melted. More specifically, the first solder 6 may be one with a lower surface tension than the second solder 7 when melted. In this case, when the first solder 6 and second solder 7 are melted, the first solder 6 with the relatively low surface tension easily spreads compared to the second solder 7. Therefore, in this structure also, alignment is possible by self-alignment effected by the first solder 6 with the lower surface tension, while the camera module 3 is supported by the second solder 7 having the relatively high surface tension.

The surface tension of the first solder 6 and second solder 7 are not particularly limited, though for example, it is preferable for the first solder 6 preferably to have the surface tension (surface tension when melted) between 3.17 × 10⁻⁴N/mm to 4.50 × 10⁻⁴N/mm, and is more preferable to be between 3.25 × 10⁻⁴N/mm to 3.86 × 10⁻⁴N/mm. The second solder 7 is not limited as long as the surface tension is higher than the first solder.

The value of the surface tension is from the measurement by DU Nony Ring Method around the melting temperature of the solder joint (for example, around 183°C).

The surface tension of the solder influences the reliability (quality) of the solder joint. Specifically, solder with high surface tension is low in wettability, therefore the quality of the solder joint is poor. Even if the reliability of the solder joint worsens due to the second solder 7 with the relatively high surface tension, the worsened parts can be covered by first solder 6.

In addition, the type of solder used in the present embodiment is not particularly limited, however it is environmentally preferable to use so-called Pb-free solder. The Pb-free solder may be, but not limited to, Sn-Ag type solder, Sn-Zn type solder, Sn-Bi type solder, Sn-In type solder or Sn-Ag-Cu type solders. More specifically, Sn-9Zn, Sn-8Zn-3Bi, Sn-9Zn-A1, Sn-8Zn-3In may be used as the first solder, and Sn-3.5Ag, Sn-3Ag-0.5Cu, Sn-3.4Ag-4.8Bi may be used as the second solder. However, the compositional proportion of the solder constituents is also not particularly limited.

In addition, the first solder 6 and second solder 7 may have flux therein. In other words, the first solder 6 and second solder 7 may be solder paste (cream solder) containing a flux agent or the like. This provides the solder with greater wettability and flowability. This gives a greater self-alignment effect.

The type of flux is not particularly limited, and may be set according to the constituents of the electrodes formed on the mounting component and board respectively. For example, the flux may be corrosive flux (ZnCl₂-NH₄Cl type mixed salt etc.), slow flux (organic acid and its derivatives etc.), non-corrosive flux (a mixture of rosin and isopropyl alcohol), aqueous flux (rosin-type flux etc.), low-residue flux (rosin-type or resin-type flux with solid constituent of 5% or less and the activating agent as organic acid) or the like.

The solder joint section 5 in the present embodiment may have the following structure. Figs. 13 and 14 are cross sectional views illustrating a different structure of a solder joint section 5.

In the structure in Fig. 1, one second solder 7 is provided per solder joint section 5, whereas in the structure in Fig. 13, plural second solder 7 (two in Fig. 13) is provided per solder joint section 5. With this structure, it is possible to stably support the camera module 3.

In the structure in Fig. 1, the board electrode 2 and the mounting electrode were flat, whereas in the structure of Fig. 14, the board electrode 2 and the mounting electrode 4 comprise a recess section 20a or 20b recessed inwards of the printed board 1 and camera module 3. In addition, the second solder 7 is constituted by a solder ball. In other words, the second solder 7 is a sphere form, without the solder ball being melted. Thus, at the time of self-alignment, the second solder 7 of a sphere form is fixed in the position where the recess section 20a and recess section 20b are facing each other, and does not go any further. Therefore, it is possible to perform alignment of board electrode 2 and mounting electrode 4 more accurately.

The method for manufacturing the camera module structure 10 in the embodiment is applicable as a method for solder mounting. With this method, it is possible to solder the board and the mounting component in high precision by self-alignment.

The invention being thus described, it will be obvious that modifications are possible within the scope of the claims. In other words, any embodiments with modifications in art incorporated within the scope of the claims are to be included within the scope of the art of the invention.

### INDUSTRIAL APPLICABILITY

The present invention, in which a solder joint section is formed from a plurality of solders, realizes alignment by self-alignment while supporting the electronic component being mounted on the board. Accordingly, the present invention is applicable to any solder mounting structure, and is applicable to the electronics component industry. Especially, the present invention is preferably applicable to the soldering of joining boards (printed board) to which heavy-weight electronic components such as camera modules (for such as digital still cameras and mobile phones) comprising a shooting lens and a solid-state image sensor integrally.

## Claims

1. A solder mounting structure wherein:
a board electrode of a board and a mounting electrode of a mounting component mounted on the board are joined with each other by a solder joint section; and
said solder joint section comprises multiple types of solder.

2. A solder mounting structure as set forth in claim 1, wherein said solder joint section comprises first solder with a relatively low melting temperature or surface tension when melted, and second solder with a higher melting temperature or surface tension than the first solder when melted.

3. A solder mounting structure as set forth in claim 1, wherein said board electrode and mounting electrode is covered with said solder joint section.

4. A solder mounting structure as set forth in claim 1, wherein:
said supporting section is spherical; and
said supporting section is sandwiched between a recess section of said board electrode and a recess section of said mounting electrode.

5. A solder mounting structure as set forth in claim 1, wherein said second solder is formed having plane contact with the board electrode and the mounting electrode.

6. A solder mounting structure as set forth in claim 1, wherein said multiple types of solder is a Pb-free solder.

7. A solder mounting structure as set forth in claim 1, wherein said mounting component is an optical element.

8. A solder mounting structure as set forth in claim 7, wherein said optical element is a camera module.

9. A solder mounting structure as set forth in claim 1, wherein said solder joint section has a larger proportion of the first solder than the second solder.

10. A solder mounting structure as set forth in claim 1, wherein said solder joint section has a larger proportion of the second solder than the first solder.

11. A method for manufacturing a solder mounting structure in which a board electrode of a board and a mounting electrode of a mounting component mounted on the board are joined with each other by a solder joint section, the method comprising:
forming the solder joint section comprising multiple types of solder; and
aligning the board electrode and the mounting electrode by self-alignment effected by the multiple types of solder.

12. A method for manufacturing solder mounting structure as set forth in claim 11, wherein a first solder with a relatively low melting temperature and a second solder with a higher melting temperature than the first solder are used as said multiple types of solder, and the method includes heating the first and second solder to a temperature equal to or higher than the melting temperature of the first solder though lower than the melting temperature of the second solder.

13. A method for manufacturing solder mounting structure as set forth in claim 11, wherein a first solder with relatively low surface tension when melted and a second solder with a higher surface tension than the first solder when melted are used as said multiple types of solder, and the method includes heating the first and second solder to a temperature equal to or higher than the melting temperature of the first solder and the second solder.

14. A method for manufacturing solder mounting structure as set forth in claim 12, wherein said second solder is a solder ball.

15. A method for manufacturing solder mounting structure as set forth in claim 12, wherein said first solder is a solder paste.

16. An electrical device comprising a solder mounting structure of any one of claims 1 through 10.

17. A solder mounting method by which a board electrode of a board and a mounting electrode of a mounting component mounted on the board are joined with each other by a solder joint section, the method comprising:
forming the solder joint section comprising multiple types of solder; and
aligning the board electrode and the mounting electrode by self-alignment effected by the multiple types of solder.
